# EUROPÄISCHE PATENTANMELDUNG

(11) **EP 4 657 094 A1**
(43) Veröffentlichungstag der Anmeldung: **03.12.2025**
(21) Anmeldenummer: 25176719.0
(22) Anmeldetag: 15.05.2025
(51) Int. Cl.: G01R 31/367, G01R 31/3842, G01R 31/396

(54) **VERFAHREN ZUR ERMITTLUNG DES LADEZUSTANDS VON BATTERIEZELLEN, RECHENEINHEIT, BATTERIE UND FAHRZEUG**

(30) Priorität: 24.05.2024 DE 102024001682
(71) Anmelder: Mercedes-Benz Group AG, 70372 Stuttgart (DE)
(72) Erfinder: WITZENHAUSEN, Heiko, 73728 Esslingen (DE); SIEHR, Jochen, 73728 Esslingen (DE)
(74) Vertreter: Weller, Jürgen

(57) **Zusammenfassung**

Die Erfindung betrifft ein Verfahren zur Ermittlung des Ladezustands (1) von Batteriezellen (2) einer Sekundärbatterie unter Berücksichtigung der Ruhespannung (3) einer respektiven Batteriezelle (2). Das erfindungsgemäße Verfahren ist gekennzeichnet durch die folgenden Verfahrensschritte:
- Starten eines Ladevorgangs der Batteriezelle (2);
- Stoppen des Ladevorgangs und Erfassen der am Ende oder im letzten Teil des Ladevorgangs an der Batteriezelle (2) anliegenden Zellspannung (4) und Stromstärke (5);
- Erfassen der sich nach dem Ladevorgang einstellenden Ruhespannung (3) der Batteriezelle (2); und
- Bestimmen des Ladezustands (1) der Batteriezelle (2) in Abhängigkeit der Ruhespannung (3) und der sich am Ende oder im letzten Teil des Ladevorgangs einstellenden Zellspannung (4) und Stromstärke (5), wobei ein Zusammenhang (6) zwischen dem Ladezustand (1), der Ruhespannung (3), der Zellspannung (4) und der Stromstärke (5) durch dem Ladevorgang vorausgehende Referenzmessungen baugleicher Batteriezellen (2) ermittelt wurde.

## Beschreibung

Die Erfindung betrifft ein Verfahren zur Ermittlung des Ladezustands von Batteriezellen einer Sekundärbatterie nach der im Oberbegriff von Anspruch 1 näher definierten Art, eine Recheneinheit nach der im Oberbegriff von Anspruch 7 näher definierten Art, eine Batterie mit wenigstens einer Batteriezelle sowie ein Fahrzeug.

Die zum Betrieb eines elektrischen Antriebsstrangs eines Fahrzeugs benötigte Antriebsenergie wird in einer sogenannten Traktionsbatterie gespeichert. Um die fahrzeugführende Person eines entsprechenden Elektrofahrzeugs über die zur Verfügung stehende Restreichweite zu informieren, ist es erforderlich die noch von der Traktionsbatterie abgebbare elektrische Energiemenge zu ermitteln. Bei herkömmlichen Batteriezellen mit Nickel-Mangan-Kobaltoxyd-Kathoden lässt sich der Ladezustand der Einzelzellen aus der Ruhespannungskennlinie eindeutig bestimmen. Während der Fahrt wird die aus der Traktionsbatterie entnommene Strommenge durch eine Integration der aus der Traktionsbatterie entnommenen Ladungsmenge ermittelt. Nach dem Abstellen des Fahrzeugs kommt es zu einer Relaxation der Batteriezellen, was er ermöglicht den Ladezustand aus der Ruhespannungskennlinie auszulesen. Dieser Wert wird dann als Startpunkt für die nächste Integrationsrechnung verwendet. Dies wird auch als Ladezustandsrekalibrierung bezeichnet. Die Genauigkeit der Ladezustandsbestimmung ist dabei abhängig von der Güte des Startwerts und dem darauf aufbauenden Integrationsfehler der Strommessung.

Bei Batteriezellen mit Lithium-Eisenphosphat-Kathode lässt sich im Gegensatz hierzu der Ladezustand nicht eindeutig aus der Ruhespannungskennlinie ermitteln, da solche Zellen ein Plateau, auch als Spannungsplateau bezeichnet, über einen weiten Ladezustandsbereich innerhalb der Ruhespannungskennlinie aufweisen. So kann beispielsweise für eine Batteriezelle die Ruhespannung in einem Ladezustandsbereich von 63% bis 93% einen konstanten Wert von 3,336 V annehmen. Wird also nach dem Relaxieren der Batteriezellen die Ruhespannung einer respektiven Batteriezelle erfasst und beträgt dieser Wert 3,336 V, so könnte diese Batteriezelle einen Ladezustand von 63% oder auch 93% gleichermaßen aufweisen. Somit kann der Integrationsfehler zur Bestimmung des Ladezustands aus der Integration über die entnommene Ladungsmenge seltener zurückgesetzt werden. Dies erschwert es die tatsächlich von der Traktionsbatterie noch abgebbare elektrische Energiemenge zu bestimmen. Entsprechend ungenau ist die im Fahrzeug ausgegebene Restreichweite.

Insbesondere bei gealterten Zellen oder aufgrund einer Disbalance zwischen mehreren Einzelzellen erreichen diese unter Umständen den oberen Ladungszustandsbereich, indem die respektiven Batteriezellen das Spannungsplateau verlassen, überhaupt nicht mehr. Eine Ladezustands-Rekalibrierung kann dann im Betrieb kaum noch möglich sein. Der Integrationsfehler wächst dann ungehindert an, sodass die angezeigte Reichweite des Fahrzeugs sowie die zulässige Ladeleistung signifikant reduziert werden, da sie von der Unschärfe des ermittelten Ladezustands abhängen.

Somit besteht der Bedarf Verfahren und Mittel anzugeben, mit denen es ermöglicht wird, den Ladezustand von Batteriezellen einer Sekundärbatterie, insbesondere von Batteriezellen mit Lithium-Eisenphosphat-Kathoden, zuverlässiger zu bestimmen.

Um diesem Problem entgegenzuwirken wird bei solchen, auch als LFP-Batterien bezeichneten Batterien, normalerweise eine aufwändigere und damit exaktere, jedoch auch teurere Strommessung durchgeführt. Der Integrationsfehler wächst dann langsamer, wobei das Problem jedoch nur aufgeschoben, nicht jedoch aufgehoben ist. Eine weitere Maßnahme ist das Erhöhen der Balancing-Leistung in einem von einem Batteriemanagementsystem ausgeführten Ladungsausgleichsverfahren. Auch dies erhöht jedoch die Kosten der Traktionsbatterie und leistet nur einen geringen Beitrag zur Ursachenbekämpfung. Aufgrund verschiedener Unsicherheiten in entsprechenden Rechenmodellen, ist auch die modellbasierte Nachführung des Ladezustands unter Last für LFP-Batterien ungeeignet, um eine zuverlässige Aussage über den Ladezustand der Batteriezellen der Traktionsbatterie zu machen.

Aus der zum Ausarbeitungszeitpunkt der Anmeldung noch nicht veröffentlichten deutschen Patentanmeldung 10 2022 004 020.4 ist ein Verfahren zum Ermitteln von Ladezuständen von Batteriezellen bekannt. Dabei wird der Ladezustand einer Batterie mit wenigstens zwei Batteriezellen während des Ladevorgangs ermittelt. Der Ladevorgang findet mit einer Konstantstrom-Ladephase und einer sich daran anschließenden Konstantspannungs-Ladephase statt. Es wird zumindest eine erste Spannung einer ersten Batteriezelle und eine zweite Spannung wenigstens einer zweiten Batteriezelle erfasst. Die beiden Batteriezellen sind in Reihe geschaltet. Während der Konstantstrom-Ladephase des Ladevorgangs wird ein erster Zeitpunkt identifiziert, zu dem die erste Spannung der ersten Batteriezelle einen vorgegebenen Spannungswert erreicht. Während der Konstantstrom-Ladephase wird ferner ein zweiter Zeitpunkt identifiziert, zudem die zweite Spannung der wenigstens einen zweiten Batteriezelle den vorgegebenen Spannungswert erreicht. Danach wird eine Ladungsdifferenz zwischen dem zweiten Zeitpunkt und dem ersten Zeitpunkt ermittelt. Der Ladezustand der wenigstens einen zweiten Batteriezelle ergibt sich aus der Ladungsdifferenz und einer Kapazität der ersten Batteriezelle nach Abschluss der Konstantstrom-Ladephase. Das aus dieser Patentanmeldung offenbarte Verfahren eignet sich insbesondere zur Vorhersage des Ladezustands von Batteriezellen mit Lithium-Eisenphosphat-Kathode.

Ferner offenbart die DE 10 2022 111 139 A1 ein Verfahren, Steuer- und/oder Regelungsmittel sowie eine Anordnung zur Ermittlung des Ladezustands eines elektrochemischen Energiespeichers. Dabei wird ein Auf- oder Entladevorgang des Energiespeichers gestartet und dann zeitgleich zu einem Zeitpunkt t eine Leerlaufspannung des Energiespeichers gemessen und der serielle Widerstand des Energiespeichers bestimmt. Der serielle Widerstand lässt sich durch elektrochemische Impedanzspektroskopie ermitteln. Der Zeitpunkt t liegt insbesondere in einer Ruhephase des Energiespeichers. Die derart ermittelten Größen werden mit Referenzwerten verglichen, aus dessen Zusammenhang der Ladezustand des Energiespeichers ermittelbar ist.

Zudem offenbart die DE 10 2022 129 545 A1 ein Verfahren zum Detektieren von Lithium-Plating in einer Lithiumionenzelle und eine Lithiumionenbatterie.

Der vorliegenden Erfindung liegt die Aufgabe zugrunde ein verbessertes Verfahren zur Ermittlung des Ladezustands von Batteriezellen einer Sekundärbatterie anzugeben, mit dessen Hilfe der Ladezustand von Batterieeinzelzellen mit wenig Aufwand genau abgeschätzt werden kann.

Erfindungsgemäß wird diese Aufgabe durch ein Verfahren zur Ermittlung des Ladezustands von Batteriezellen mit den Merkmalen des Anspruchs 1 gelöst. Vorteilhafte Ausgestaltungen und Weiterbildungen sowie eine Recheneinheit zur Ausführung des Verfahrens, eine Batterie und ein Fahrzeug ergeben sich aus den hiervon abhängigen Ansprüchen.

Ein gattungsgemäßes Verfahren zur Ermittlung des Ladezustands von Batteriezellen einer Sekundärbatterie unter Berücksichtigung der Ruhespannung einer respektiven Batteriezelle wird erfindungsgemäß durch die folgenden Verfahrensschritte weitergebildet:
- Starten eines Ladevorgangs der Batteriezelle;
- Stoppen des Ladevorgangs und Erfassen der am Ende des Ladevorgangs an der Batteriezelle anliegenden Zellspannung und Stromstärke und/oder Erfassen der während des Ladevorgangs an der Batteriezelle anliegenden Zellspannung und Stromstärke;
- Erfassen der sich nach dem Ladevorgang einstellenden Ruhespannung der Batteriezelle; und
- Bestimmen des Ladezustands der Batteriezelle in Abhängigkeit der Ruhespannung und der sich am Ende des Ladevorgangs einstellenden Zellspannung und Stromstärke, wobei ein Zusammenhang zwischen dem Ladezustand, der Ruhespannung, der Zellspannung und der Stromstärke durch dem Ladevorgang vorausgehende Referenzmessungen baugleicher Batteriezellen ermittelt wurde.

Die Anmelderin hat erkannt, dass es einen Zusammenhang zwischen dem Ladezustand von Batteriezellen und der Ruhespannung nach Relaxation der respektiven Batteriezelle sowie den am Ende oder im letzten Teil des Ladevorgangs vorliegenden Zellspannung und Stromstärke gibt. Dieser Zusammenhang kann beispielsweise in Form eines Kennfelds oder einer Liste, beispielsweise tabellarisch, erfasst und gespeichert werden. Eine solche Liste kann auch als Tupel aufgefasst werden und in Form einer Matrix bzw. eines Tensors definiert werden. Hierzu werden mit geeigneter Messtechnik entsprechende Referenzmessungen vorab durchgeführt. Dies ermöglicht es in Abhängigkeit der drei Größen: "Ruhespannung", "Zellspannung" und "Stromstärke" zuverlässig den Ladezustand zu ermitteln. Die Ruhespannung stellt sich dabei an der Batteriezelle nach dem Relaxieren ein. Bei der Zellspannung und Stromstärke handelt es sich um die jeweiligen Werte am Ende oder im letzten Teil des Ladevorgangs. Insbesondere wird dabei die Batteriezelle oder eine mit der Batteriezelle in Reihe geschaltete weitere Batteriezelle vollgeladen. Bei der Zellspannung kann es sich dann um die sogenannte Ladeschlussspannung handeln.

Es kann beispielsweise eine Ruhespannung in Höhe von 3,336 V gemessen werden. Die Batteriezelle kann ein mehr oder weniger stark ausgeprägtes Spannungsplateau aufweisen. Reicht der Ladezustandsbereich mit Spannungsplateau beispielsweise von 30% bis 90%, so kann der Ladezustand der Batteriezelle alleinig unter Berücksichtigung der Ruhespannung nicht genau abgeschätzt werden. Wird nun beispielsweise am Ende des Ladevorgangs eine Zellspannung und eine Stromstärke von mindestens 3,550 V bzw. höchstens 5 A gemessen, so birgt dieser zweite Messzustand die Information, dass der Ladezustand auf jeden Fall größer ist als beispielsweise 85%. Unter Berücksichtigung beider Informationen dieser Werte kann dann der Ladezustand der Batteriezelle beispielsweise auf einen Bereich von 85% bis 90% eingeschränkt werden. Anstelle von Ladezustandsbereichen kann in dem jeweiligen Zusammenhang auch ein Einzelwert wie beispielsweise 90,0% hinterlegt sein.

Eine vorteilhafte Ausgestaltung des erfindungsgemäßen Verfahrens sieht dabei vor, dass die Batteriezelle mit einem IU-Ladeverfahren geladen wird. Das IU-Ladeverfahren wird auch als CCCV-Ladeverfahren bezeichnet. Die englische Übersetzung lautet: "Constant Current Constant Voltage" und meint ein Ladeverfahren, bei dem sich eine Konstantspannungsladephase an eine Konstantstromladephase anschließt. Dieses Ladeverfahren wird besonders häufig zum Laden von Traktionsbatterien von Fahrzeugen eingesetzt. Mit Hilfe des IU-Ladeverfahrens ist eine schonende und schnelle Ladung einer die Batteriezelle umfassenden Sekundärbatterie möglich.

Entsprechend einer weiteren vorteilhaften Ausgestaltung des erfindungsgemäßen Verfahrens ist es ferner vorgesehen, dass der Zusammenhang zwischen dem Ladezustand, der Ruhespannung, der Zellspannung und der Stromstärke abhängig von der Zelltemperatur und/oder der Zellalterung ermittelt wird. So können die zur Erhebung des Zusammenhangs durchgeführten Referenzmessungen auch für Batteriezellen unterschiedlicher Temperatur und/oder Alterungsgrad durchgeführt werden. Der Alterungsgrad kann mit Hilfe bewährter Größen angegeben werden, wie beispielsweise dem SOH (State-Of-Health). Dies ermöglicht es von der jeweiligen Zelltemperatur und dem jeweiligen Alterungsgrad abhängige Zusammenhänge zwischen dem Ladezustand und den drei abhängigen Größen "Ruhespannung", "Zellspannung" und "Stromstärke" zu erfassen. Dies ermöglicht es im Einsatz noch genauere Werte für den Ladezustand der Batteriezelle zu ermitteln.

Eine weitere vorteilhafte Ausgestaltung des erfindungsgemäßen Verfahrens sieht ferner vor, dass die Batteriezelle in ein Batteriemodul integriert ist, umfassend wenigstens zwei in Reihe geschaltete Batteriezellen, wobei der Ladezustand jeder Batteriezelle individuell bestimmt wird. Mit Hilfe des erfindungsgemäßen Verfahrens kann nicht nur der Ladezustand einer einzelnen Batterieeinzelzelle, sondern auch mehrerer Batterieeinzelzellen ein und desselben Batteriemoduls bestimmt werden. Dies ermöglicht es letztendlich auch den Ladezustand des gesamten Batteriemoduls sowie eine ein oder mehrere Batteriemodule umfassende Traktionsbatterie zu ermitteln.

Dabei können auch mehrere Batteriezellen bzw. Batteriemodule parallel zueinander geschaltet sein. Somit lässt sich für eine das oder die Batteriemodule umfassende Traktionsbatterie eine gewünschte Spannung sowie eine gewünschte Kapazität einstellen.

Entsprechend einer weiteren vorteilhaften Ausgestaltung des erfindungsgemäßen Verfahrens wird das Batteriemodul so lange geladen, bis eine erste Batteriezelle vollgeladen ist. Das erfindungsgemäße Verfahren zum Bestimmen des Ladezustands der Batteriezellen sieht also vor, eine entsprechende Sekundärbatterie so lange zu laden, bis die erste Batteriezelle vollgeladen ist. Danach wird gewartet, bis der Relaxationsvorgang der Batteriezellen abgeschlossen ist. Danach wird der Ladezustand basierend auf dem Zusammenhang ermittelt. Dass die erste Batteriezelle vollgeladen ist kann anhand bewährter Methoden festgestellt werden. Beispielsweise kann im IU-Ladeverfahren festgestellt werden, das eine erste Batteriezelle vollgeladen ist, wenn eine erste Batteriezelle einen Grenzladestrom unterschreitet.

Eine weitere vorteilhafte Ausgestaltung des erfindungsgemäßen Verfahrens sieht ferner vor, dass der für jede Batteriezelle ermittelte Ladezustand für die Durchführung eines Ladungsausgleichverfahrens berücksichtigt wird. Das Ladungsausgleichverfahren wird im Englischen auch als "Cell-Balancing" bezeichnet. Dabei kann zwischen aktives und passives Balancieren differenziert werden. Der mittels des erfindungsgemäßen Verfahrens abgeschätzte Ladezustand der Batteriezellen kann sowohl für das aktive, als auch das passive Zell-Balancieren eingesetzt werden. Da für jeweilige Batteriezellen nun noch genauer ein jeweiliger Ladezustand ermittelt werden kann, lassen sich auch die Batterieeinzelzellen noch gleichmäßiger ausbalancieren.

Eine gattungsgemäße Recheneinheit, umfassend ein computerlesbares Speichermedium, einen Prozessor und Mittel zum Erfassen der Ruhespannung, Zellspannung und Stromstärke von Batteriezellen, wird erfindungsgemäß dadurch weitergebildet, dass auf dem computerlesbaren Speichermedium der Zusammenhang zwischen dem Ladezustand, der Ruhespannung, der Zellspannung und der Stromstärke sowie ein Computerprogrammprodukt gespeichert ist, das Computerprogrammprodukt umfassend maschineninterpretierbare Anweisungen, die bei einer Ausführung durch den Prozessor diesen dazu befähigen ein im vorigen beschriebenes Verfahren bereitzustellen. Die Recheneinheit kann in diesem Kontext auch als Batteriemanagementsystem bezeichnet werden. Auch kann es sich um eine zur Batterie externe Recheneinheit handeln, die auch als Steuergerät für die Batterie bezeichnet werden kann. Auf dem computerlesbaren Speichermedium ist zudem der Zusammenhang zwischen dem Ladezustand, der Ruhespannung, der Zellspannung und der Stromstärke, beispielsweise in Form einer Tabelle oder besagten Kennfelds, gespeichert. Da die Recheneinheit dazu in der Lage ist die jeweiligen Größen mittels geeigneter Überwachungsvorrichtungen zu messen oder von einer geeigneten externen Quelle zu empfangen, kann die Recheneinheit durch Auslesen der jeweiligen Größen und des Zusammenhangs den Ladezustand der Batterieeinzelzelle bzw. Batteriezellen ermitteln. Die Recheneinheit kann den für jede Batteriezelle ermittelten Ladezustand dann selbst weiterverarbeiten oder an eine weitere Recheneinheit ausgeben. Die Recheneinheit verfügt über entsprechende Kommunikationsmittel, wie beispielsweise eine Kommunikationsschnittstelle in Form eines Anschlusses für einen Feldbus. Beispielsweise kann es sich dabei um eine Ethernet-Datenleitung oder einen CAN-Bus handeln.

Eine Batterie, umfassend wenigstens eine Batteriezelle, weist erfindungsgemäß eine solche Recheneinheit auf.

Besonders bevorzugt weist die Batteriezelle der Batterie dabei eine Lithium-Eisenphosphat-Kathode auf. Batteriezellen mit Lithium-Eisenphosphat-Kathoden, also entsprechende LFP-Batterien, zeichnen sich durch ein ausgeprägtes Spannungsplateau in der Ruhespannungskennlinie aus. Entsprechend eignet sich das erfindungsgemäße Verfahren zum Abschätzen des Ladezustands von Batteriezellen für solche LFP-Batterien.

Ein Fahrzeug weist erfindungsgemäß eine im vorigen beschriebene Recheneinheit bzw. Batterie auf. Das Fahrzeug kann dabei rein batterieelektrisch angetrieben sein oder auch als Hybridfahrzeug, insbesondere Plugin-Hybrid, ausgeführt sein. Es kann sich um ein Straßenfahrzeug wie einen Pkw, Lkw, Transporter, Bus oder dergleichen handeln. Generell ist es auch denkbar, dass es sich auch um ein Schienenfahrzeug, Wasserfahrzeug oder Luftfahrzeug handeln könnte.

Weitere vorteilhafte Ausgestaltungen des erfindungsgemäßen Verfahrens zur Ermittlung des Ladezustands von Batteriezellen einer Sekundärbatterie sowie der erfindungsgemäßen Recheneinheit, Batterie und des Fahrzeugs ergeben sich auch aus den Ausführungsbeispielen, welche nachfolgend unter Bezugnahme auf die Figuren näher beschrieben werden.

Dabei zeigen:
- Fig. 1: eine Ruhespannungskennlinie einer Batteriezelle mit Lithium-Eisenphosphat-Kathode;
- Fig. 2: eine schematische Draufsicht auf ein erfindungsgemäßes Fahrzeug; und
- Fig. 3: eine schematische Darstellung der Ermittlung des Ladezustands von Batteriezellen unter Berücksichtigung der in Fig. 1 gezeigten Ruhespannungskennlinie sowie eines Zusammenhangs zwischen dem Ladezustand, der Ruhespannung, der Zellspannung und der Stromstärke.

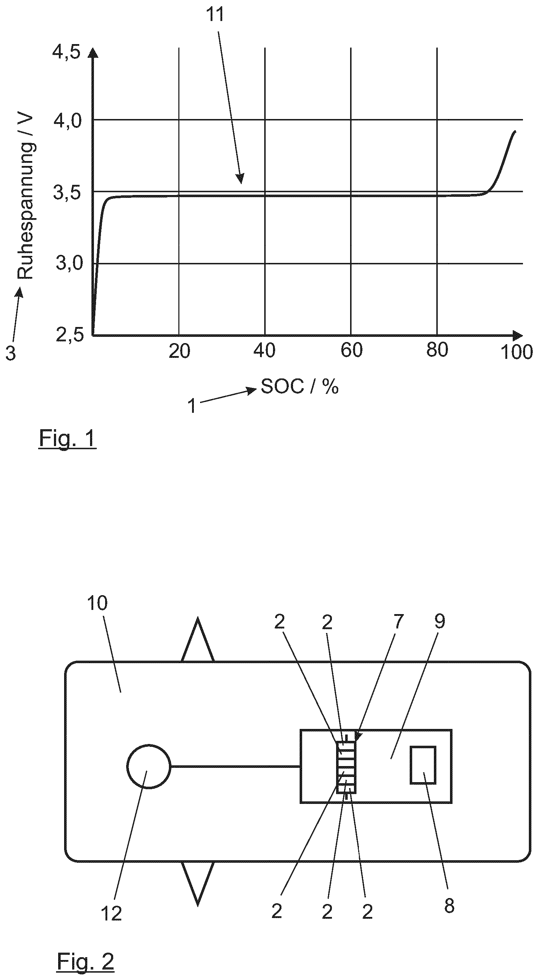

Figur 1 zeigt schematisch eine Ruhespannungskennlinie einer in Figur 2 gezeigten Batteriezelle 2 mit Plateauphasen ähnlich einer Batteriezelle mit Lithium-Eisenphosphat-Kathode. Dabei ist auf der Abszisse des Diagramms der Ladezustand 1, abgekürzt als SOC (State-of-Charge), in Prozent aufgetragen. Auf der Ordinate ist die Ruhespannung 3 der Batteriezelle 2 nach dem Relaxieren aufgetragen. Wie zu erkennen ist, weist die Ruhespannungskennlinie in dieser beispielhaften Darstellung ein ausgeprägtes Spannungsplateau 11 fast über den vollständigen Ladezustand 1 auf. Wird also die Ruhespannung 3 gemessen, so kann keine eindeutige Aussage darüber gemacht werden, welchen Ladezustand 1 die Batteriezelle 2 aufweist.

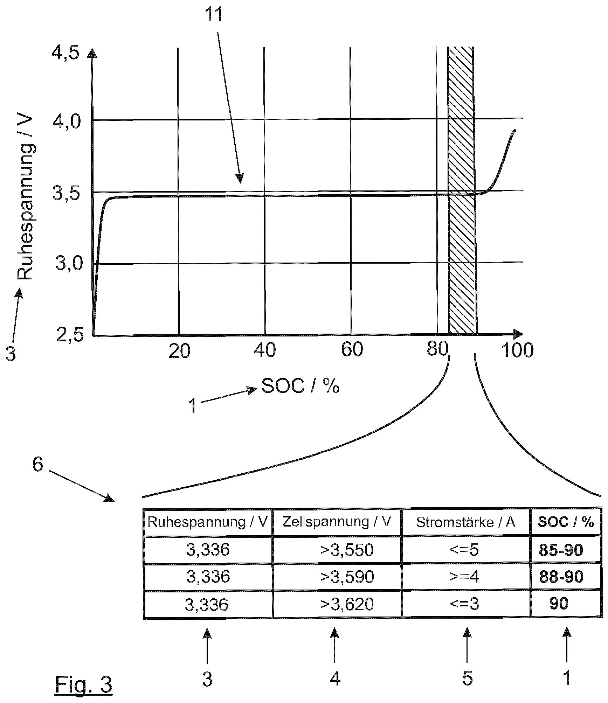

Figur 2 zeigt eine Draufsicht auf ein erfindungsgemäßes Fahrzeug 10. Hierbei handelt es sich um ein rein batterieelektrisch angetriebenes Straßenfahrzeug. Das Fahrzeug 10 umfasst ein elektrisches Antriebsaggregat 12, welches elektrische Antriebsenergie von einer Batterie 9, auch als Traktionsbatterie bezeichnet, bezieht. Die Batterie 9 umfasst ferner wenigstens ein Batteriemodul 7, wiederum aufweisend zumindest eine Batteriezelle 2, insbesondere mehrere in Reihe geschaltete Batteriezellen 2. In einem Batteriemodul 7 können auch mehrere Batteriezellen 2 parallel zueinander geschaltet sein (nicht dargestellt). Bevorzugt umfasst die Batterie 9 mehrere in Reihe und/oder parallel geschaltete Batteriemodule 7. Ferner umfasst die Batterie 9 eine Recheneinheit 8, welche auch als Batteriemanagementsystem bezeichnet werden kann. Die Recheneinheit 8 zur Steuerung des Betriebsverhaltens der Batterie 9 könnte generell auch extern zur Batterie 9 ausgeführt sein. Die Recheneinheit 8 umfasst ein computerlesbares Speichermedium sowie einen Prozessor und Mittel zum Erfassen der in Figur 3 gezeigten Ruhespannung 3, Zellspannung 4 und Stromstärke 5 der Batteriezellen 2. Auf dem computerlesbaren Speichermedium ist der ebenfalls in Figur 3 gezeigte Zusammenhang 6 zwischen dem Ladezustand 1, der Ruhespannung 3, der Zellspannung 4 und der Stromstärke 5 gespeichert. Zudem enthält das Computerprogrammprodukt maschineinterpretierbare Anweisungen, die bei einer Ausführung durch den Prozessor diesen dazu befähigen das erfindungsgemäße Verfahren bereitzustellen.

Das Funktionsprinzip des erfindungsgemäßen Verfahrens zur Bestimmung des Ladezustands 1 wird anhand von Figur 3 verdeutlicht. Figur 3 zeigt noch einmal die in Figur 1 dargestellte Ruhespannungskennlinie. Unter Berücksichtigung des Zusammenhangs 6 lässt sich dann der Ladezustand 1 der Batteriezelle(n) 2 bzw. des oder der Batteriemodule 7 bzw. der Batterie 9 auf einen engeren Bereich, besonders bevorzugt einen "genauen" Wert, abschätzen. Dieser Bereich ist in Figur 3 schraffiert angedeutet. Die dabei in dem durch eine Tabelle veranschaulichten Zusammenhang 6 eingetragenen Werte entsprechen nur Beispielgrößen. Wie der Zusammenhang 6 veranschaulicht, können dabei einzelne Einträge durch Einzelwerte oder auch durch Intervallangaben ausgebildet sein. Der Inhalt des Zusammenhangs 6 ergibt sich durch vor der Ausführung des erfindungsgemäßen Verfahrens durchgeführte Referenzmessungen. Diese Referenzmessungen können auf einem Prüfstand oder auch mit Hilfe eines Messfahrzeugs durchgeführt worden sein. Beispielsweise erfolgen die Referenzmessungen während der Entwicklung des elektrischen Antriebsstrangs des Fahrzeugs 10.

Mit Hilfe des erfindungsgemäßen Verfahrens lässt sich der Ladezustand 1 für Batteriezellen 2, besonders bevorzugt für die Traktionsbatterie des Fahrzeugs 10, noch genauer abschätzen. Da lediglich die drei Größen "Ruhespannung" 3, "Zellspannung" 4 und "Stromstärke" 5 erfasst werden und der sich einstellende Ladezustand 1 aus dem Zusammenhang 6 ausgelesen werden muss, lässt sich der Ladezustand 1 einfach und mit geringem technischen Aufwand schätzen. Insbesondere wird es somit ermöglicht den Ladezustand 1 für Batteriezellen mit Lithium-Eisenphosphat-Kathode noch genauer zu schätzen.

Durch das Ermitteln eines zellalterungsabhängigen und/oder temperaturabhängigen Zusammenhangs 6 kann auch eine ausreichend genaue Rekalibrierung des Ladezustands nach Ende der Ladung für gealterte Traktionsbatterien über ein breites Temperaturkennfeld erfolgen. Das in dieser Anmeldung offenbarte erfindungsgemäße Verfahren kann besonders vorteilhaft mit dem aus der noch nicht veröffentlichten deutschen Patentanmeldung 10 2022 004 020.4 bekannten Verfahren kombiniert werden. Dies ermöglicht eine noch genauere Ermittlung des Ladezustands 1 für Batterien 8, deren Batterieeinzelzellen ein besonders ausgeprägtes Disbalancing aufweisen. Somit können vielfältige Ursachen für Ladezustandsunschärfen nach Vollladung mitigiert werden. Kostenintensive Gegenmaßnahmen, wie das Vorsehen aufwändiger und damit teurer Hardware im Fahrzeug 10, können somit entfallen. Sowohl die Reichweitenanzeige als auch der zugelassene Ladestrom kommen ohne große Abschläge aufgrund von Ladezustandsunschärfe aus.

## Patentansprüche

1. Verfahren zur Ermittlung des Ladezustands (1) von Batteriezellen (2) einer Sekundärbatterie unter Berücksichtigung der Ruhespannung (3) einer respektiven Batteriezelle (2), **gekennzeichnet durch** die folgenden Verfahrensschritte:
- Starten eines Ladevorgangs der Batteriezelle (2);
- Stoppen des Ladevorgangs und Erfassen der am Ende des Ladevorgangs oder in dessen letztem Abschnitt an der Batteriezelle (2) anliegenden Zellspannung (4) und Stromstärke (5);
- Erfassen der sich nach dem Ladevorgang einstellenden Ruhespannung (3) der Batteriezelle (2); und
- Bestimmen des Ladezustands (1) der Batteriezelle (2) in Abhängigkeit der Ruhespannung (3) und der sich am Ende des Ladevorgangs oder dessen letzten Abschnitt einstellenden Zellspannung (4) und Stromstärke (5), wobei ein Zusammenhang (6) zwischen dem Ladezustand (1), der Ruhespannung (3), der Zellspannung (4) und der Stromstärke (5) durch dem Ladevorgang vorausgehende Referenzmessungen baugleicher Batteriezellen (2) ermittelt wurde.

2. Verfahren nach Anspruch 1,
**dadurch gekennzeichnet, dass**
die Batteriezelle (2) mit einem IU-Ladeverfahren geladen wird.

3. Verfahren nach Anspruch 1 oder 2,
**dadurch gekennzeichnet, dass**
der Zusammenhang (6) zwischen dem Ladezustand (1), der Ruhespannung (3), der Zellspannung (4) und der Stromstärke (5) abhängig von der Zelltemperatur und/oder der Zellalterung ermittelt wird.

4. Verfahren nach einem der Ansprüche 1 bis 3,
**dadurch gekennzeichnet, dass**
die Batteriezelle (2) in ein Batteriemodul (7) integriert ist, umfassend wenigstens zwei in Reihe geschaltete Batteriezellen (2), wobei der Ladezustand (1) jeder Batteriezelle (2) individuell bestimmt wird.

5. Verfahren nach Anspruch 4,
**dadurch gekennzeichnet, dass**
das Batteriemodul (7) so lange geladen wird, bis eine erste Batteriezelle (2) vollgeladen ist.

6. Verfahren nach Anspruch 4 oder 5,
**dadurch gekennzeichnet, dass**
der für jede Batteriezelle (2) ermittelte Ladezustand (1) für die Durchführung eines Ladungsausgleichsverfahrens berücksichtigt wird.

7. Recheneinheit (8), umfassend ein computerlesbares Speichermedium, einen Prozessor und Mittel zum Erfassen der Ruhespannung (3), Zellspannung (4) und Stromstärke (5) von Batteriezellen (2),
**dadurch gekennzeichnet, dass**
auf dem computerlesbaren Speichermedium der Zusammenhang (6) zwischen dem Ladezustand (1), der Ruhespannung (3), der Zellspannung (4) und der Stromstärke (5) sowie ein Computerprogrammprodukt gespeichert ist, das Computerprogrammprodukt umfassend maschineninterpretierbare Anweisungen, die bei einer Ausführung durch den Prozessor diesen dazu befähigen das Verfahren nach einem der Ansprüche 1 bis 6 bereitzustellen.

8. Batterie (9), umfassend wenigstens eine Batteriezelle (2),
**gekennzeichnet durch**
eine Recheneinheit (8) nach Anspruch 7.

9. Batterie (8) nach Anspruch 8,
**dadurch gekennzeichnet, dass**
die wenigstens eine Batteriezelle (2) eine Lithium-Eisenphosphat-Kathode aufweist.

10. Fahrzeug (10),
**gekennzeichnet durch**
eine Recheneinheit (8) nach Anspruch 7 oder eine Batterie nach Anspruch 8 oder 9.
